# EUROPEAN PATENT APPLICATION

(11) **EP 3 252 889 A1**
(43) Date of publication of application: **06.12.2017**
(21) Application number: 16743011.5
(22) Date of filing: 04.01.2016
(51) Int. Cl.: H01S 5/024, G02B 26/10

(54) **LIGHT MODULE AND SCANNING TYPE IMAGE DISPLAY DEVICE**

(30) Priority: 26.01.2015 JP 2015011940
(71) Applicant: Hitachi-LG Data Storage, Inc., Tokyo, 108-0022 (JP)
(72) Inventor: KATOU, Seiichi, Tokyo 100-8280 (JP); OTSUBO, Ayano, Tokyo 100-8280 (JP); YAMASAKI, Tatsuya, Tokyo 108-0022 (JP); OGASAWARA, Hiroshi, Tokyo 108-0022 (JP); WATABE, Kenji, Hitachi-shi, Ibaraki 319-1221 (JP); YOSHIMURA, Yasuhiro, Tokyo 100-8280 (JP)
(74) Representative: MERH-IP Matias Erny Reichl Hoffmann Patentanwälte PartG mbB
(86) International application number: PCT/JP2016/050004
(87) International publication number: WO 2016/121407

(57) **Abstract**

To provide an optical module and a scan-type image projection display device at low power consumption in a configuration of enhancing a heat radiation property with excellent assembly performance.

An optical module 101 for coupling and irradiating laser beams from a plurality of laser diodes 1a, 1b, and 1c onto a desired position is characterized in that a first protruded part 11a corresponding to a first laser holder 10a for holding a first laser diode 1a and a second protruded part 11b corresponding to a second laser holder 10b for holding a second laser diode 1b are provided on a base 112 for placing the optical module 101 thereon, and heat conductive materials 16a and 16b are provided between the first protruded part 11a and the first laser holder 10a and between the second protruded part 11b and the second laser holder 10b, respectively.

## Description

### Technical Field

The present invention relates to an optical module and a scan-type image projection display device, and, for example, relates to an optical module for arranging and emitting laser beams from a plurality of lasers on one optical axis, and a scan-type image projection display device for displaying an image by use of laser beams from the optical module.

### Background Art

In recent years, there have been actively developed small-size projectors capable of being easily carried and displaying on a large screen. Small-size projectors connectable to a notebook-type PC or the like, or video cameras incorporating a projector capable of projecting a recorded image have been commercially available, and projectors or video cameras incorporated in a cell phone or Smartphone would be available in the future.

A scan-type image projection display device for coupling and scanning beams from a plurality of laser diodes is known as one of the projectors, which is assumed to be mounted on automobiles and the like, to project on a front glass, and to be developed into a head up display such as navigation display by use of high illuminance of images. On the other hand, a laser diode, particularly a red laser diode is characterized in that a reduction in the amount of lights due to an increase in temperature is conspicuous. When the temperature of a red laser diode increases and the amount of lights reduces over use time in a scan-type image projection display device for drawing an image by use of three colors of red, green, and blue, the amounts of lights of green and blue need to be reduced according to the amount of lights of red. Therefore, there arises a problem that video cannot be kept bright for a long time. Thus, it is important to restrict an increase in temperature of the red diode and to restrict a reduction in the amount of lights in order to achieve bright video.

As a solution thereof, there is disclosed in (PTL 1) a method for radiating heat via a heat conduction part between a first support member and a second support member for supporting a laser diode sub-assembly. (PTL 1) discloses that heat from a laser diode is transferred to the first support member via the sub-assembly and further transferred to the second support member via the heat conduction part thereby to restrict an increase in temperature of the laser diode.

### Citation List

### Patent Literature

PTL 1: Japanese Patent Application Laid-Open No. 2004-170809

### Summary of Invention

### Technical Problem

An enhancement in heat radiation property is required for optical modules used at a high temperature, such as head up display mounted on automobiles and the like.

However, the configuration of (PTL 1) has a problem that the number and sizes of parts increase in order to further enhance heat radiation property.

It is an object of the present invention to provide an optical module and a scan-type image projection display device including a simple configuration of enhancing a heat radiation property of a laser diode without an increase in size of the device.

### Solution to Problem

In order to solve the above issue, the present invention is an optical module for coupling and irradiating laser beams from a plurality of laser diodes onto a desired position, the optical module having a base for placing the optical module thereon, and a cover for covering the optical module, wherein the base is provided with a protruded part, and a heat conductive material is provided between the protruded part and a laser holder for holding a laser diode.

According to the present invention, in the optical module, the base for placing the optical module thereon is provided with a first protruded part corresponding to a first laser holder for holding a first laser diode, and a second protruded part corresponding to a second laser holder for holding a second laser diode, and a heat conductive material is provided between the first protruded part and the first laser holder and between the second protruded part and the second laser holder.

According to the present invention, in the optical module, the first laser diode is a red laser diode and the second laser diode is a green laser.

According to the present invention, in the optical module, a distance between a protruded part in an optical axis direction of a laser diode and the laser holder, in which a heat conductive material is applied, is shorter than a distance between a protruded part in a direction other than the optical axis of the laser diode and the laser holder, in which a heat conductive material is applied.

According to the present invention, in the optical module, a plane of a protruded part having a similar shape to a laser holder is provided on at least two planes other than a plane in an opposite direction to the laser holder in which the optical module is attached on the base and a plane of a module casing 4 in which the laser holder is attached, and a heat conductive material is provided between the protruded part and the laser holder.

According to the present invention, in the optical module, the laser holder is extended in a direction in which the optical module is attached on the base viewed from the laser holder, and a heat conductive material is provided between the extended laser holder and a protruded part.

According to the present invention, in the optical module, a cover is provided with the protruded part.

In order to solve the above issue, a scan-type image projection display device according to the present invention includes: an optical module for coupling laser beams from a plurality of laser diodes, and irradiating the laser beams coupled by a scanning mirror onto a desired position; a video signal processing circuit for extracting a horizontal synchronization signal and a vertical synchronization signal from an externally-input image signal; a laser diode drive circuit for supplying a drive current to each of the laser diodes; and a scanning mirror drive circuit for controlling the scanning mirror on the basis of the horizontal synchronization signal and the vertical synchronization signal, wherein a base for placing the optical module thereon is provided with a first protruded part corresponding to a first laser holder for holding a first laser diode and a second protruded part corresponding to a second laser holder for holding a second laser diode, and a heat conductive material is provided between the first protruded part and the first laser holder and between the second protruded part and the second laser holder.

### Advantageous Effects of Invention

According to the present invention, it is possible to efficiently restrict an increase in temperature of a red laser diode without an increase in size of a device. Thereby, a reduction in the amount of lights of the red laser diode can be restricted, thereby achieving an optical module and a scan-type image projection display device capable of keeping bright video for a long time. Further, it is possible to provide an optical module and a scan-type image projection display device capable of displaying bright video at low power consumption.

The problems, configurations, and effects other than the above-described ones will be apparent in the following description of embodiments.

### Brief Description of Drawings

[FIG. 1] FIG. 1 is a configuration diagram of an entire scan-type image projection display device according to one embodiment of the present invention.
[FIG. 2] FIG. 2 is a perspective view of an appearance of the scan-type image projection display device according to one embodiment of the present invention.
[FIG. 3] FIG. 3 is a perspective view illustrating a configuration of protruded parts according to one embodiment of the present invention.
[FIG. 4] FIG. 4 is a perspective view of part of an optical module illustrating the configuration of a protruded part according to one embodiment of the present invention.
[FIG. 5] FIG. 5 is a cross-section view of a configuration of a protruded part according to a second embodiment.
[FIG. 6] FIG. 6 is a perspective view illustrating a configuration of protruded parts according to a third embodiment.
[Fig. 7] FIG. 7 is a cross-section view of a configuration of a protruded part according to a fourth embodiment of the present invention.

### Description of Embodiments

Embodiments of the present invention will be described below with reference to the drawings. The components denoted with the same reference numerals have the same functions, respectively, and the description of the previously-described components will be omitted unless particularly stated.

Further, the orthogonal coordinate axes made of x-axis, y-axis, and z-axis are described in Figures as needed in order to clearly describe the position of each unit.

### First embodiment

An optical module 101 and a scan-type image projection display device 110 using the same, which realize an object of restricting an increase in temperature of a red laser diode and keeping bright video for a long time without an increase in size of the device or an increase in power consumption, will be described according to the present embodiment by way of example.

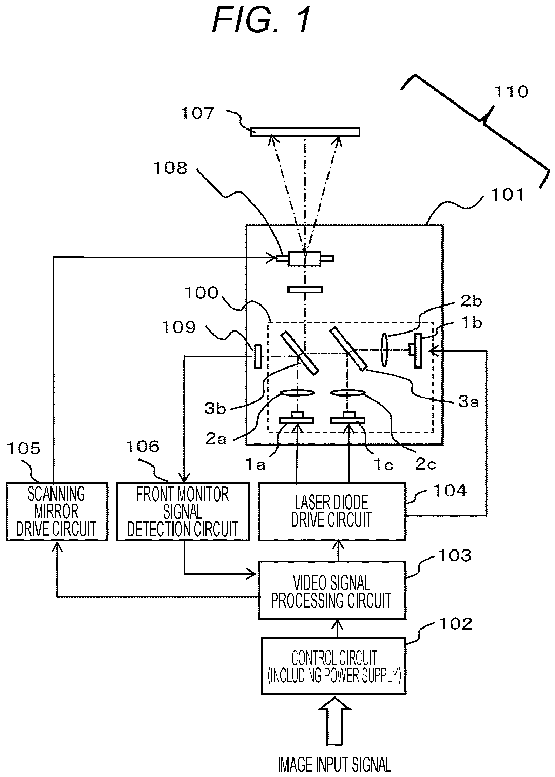

FIG. 1 is a configuration diagram of an entire scan-type image projection display device according to one embodiment of the present invention. As illustrated in FIG. 1, the scan-type image projection display device 110 is configured of the optical module 101, a control circuit 102 incorporating a power supply therein, a video signal processing circuit 103, a laser diode drive circuit 104, a front monitor signal detection circuit 106, and a scanning mirror drive circuit 105, and is configured to scan and project a laser beam corresponding to an image input signal onto a screen 107.

The optical module 101 includes a laser diode module 100, a scanning unit including a scanning mirror 108, and a front monitor 109. The laser diode module 100 has a first laser 1a, a second laser 1b, and a third laser 1c which are laser diodes corresponding to the three colors of red (R), green (G), and blue (B), respectively, and a first collimator lens 2a for making laser beams emitted from the first laser 1a substantially parallel, a second collimator lens 2b for making laser beams emitted from the second laser 1b substantially parallel, and a third collimator lens 2c for making laser beams emitted from the third laser 1c substantially parallel. A laser beam from the second collimator lens 2b and a laser beam from the third collimator lens 2c are coupled into a combined beam traveling along one axis by a first beam coupling unit 3a, and the coupled laser beam is further coupled with a laser beam from the first collimator lens 2a by a second beam coupling unit 3b. The scanning unit including the scanning mirror 108 projects the coupled laser beam from the second beam coupling unit 3b onto the screen 107, and two-dimensionally scans the laser beam on the screen 107.

Various circuits capable of controlling the optical module 101 and projecting a laser beam corresponding to a desired image signal onto the screen 107 will be described below.

The control circuit 102 incorporating the power supply and the like fetches and outputs an externally-input image signal to the video signal processing circuit 103. The video signal processing circuit 103 performs various kinds of processing on the input image signal, and then separates it into three color signals of R, G, and B, and outputs the three color signals to the laser diode drive circuit 104, and extracts a horizontal synchronization signal (Hsync) and a vertical synchronization signal (Vsync) from the input image signal and outputs them to the scanning mirror drive circuit 105. The laser diode drive circuit 104 supplies a corresponding laser diode (1a, 1b, or 1c) in the laser diode module 100 with a light emission drive current depending on the luminance value of each signal of R, G, or B input from the video signal processing circuit 103. Consequently, the laser diode 1a, 1b, or 1c emits a laser beam with an intensity depending on the luminance value of a signal of R, G, or B at a display timing.

Further, the scanning mirror drive circuit 105 supplies the scanning mirror 108 in the optical module 101 with a drive signal for repeatedly rotating the mirror face two-dimensionally according to the horizontal synchronization signal and the vertical synchronization signal input from the video signal processing circuit 103. Thereby, the scanning mirror 108 repeatedly rotates the mirror face by a predetermined angle periodically, reflects the coupled laser beam supplied from the second beam coupling unit 3b, and scans the laser beam on the screen 107 in the horizontal direction and in the vertical direction thereby to display an image.

The front monitor signal detection circuit 106 inputs a signal from the front monitor 109 for detecting the coupled laser beam from the second beam coupling unit 3b, and detects the output level of the laser beam of R, G, or B emitted from each laser diode 1a, 1b, or 1c. The detected output level is input into the video signal processing circuit 103, and a drive current to each laser diode 1a, 1b, or 1c is adjusted by the laser diode drive circuit 104 to be predetermined output.

The scanning mirror 108 can employ a 2-axis driven mirror created in the MEMS (Micro Electro Mechanical Systems) technique, for example. The drive system is piezoelectric drive, electrostatic, drive, electromagnetic drive, or the like. Further, two 1-axis driven scanning mirrors may be prepared to scan laser beams in mutually-orthogonal directions.

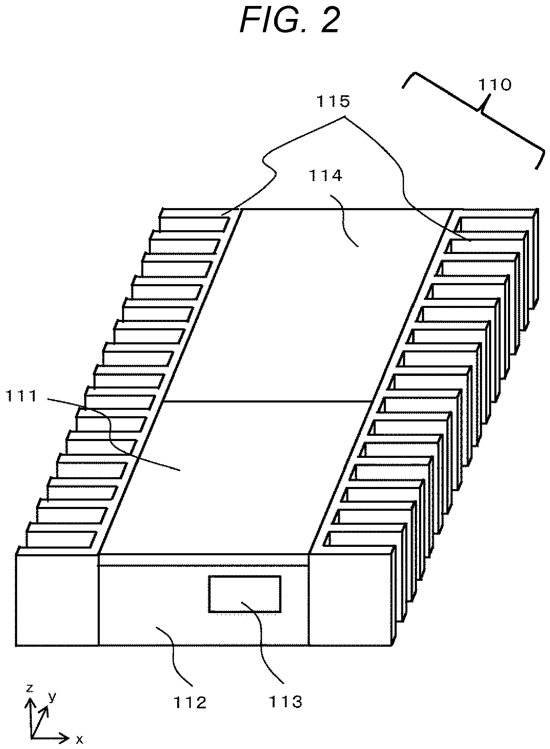

FIG. 2 is a perspective view of an appearance of the scan-type image projection display device according to one embodiment of the present invention. In FIG. 2, the optical module 101 is sealed and housed in a place covered with a cover 111 and a base 112. The base 112 is provided with an emission port capable of emitting a coupled laser beam, where sealing glass 113 is equipped to keep air tightness. The control circuit 102 for controlling the optical module 101, the video signal processing circuit 103, the laser diode drive circuit 104, the front monitor signal detection circuit 106, and the scanning mirror drive circuit 105 are mounted on the same substrate or a plurality of substrates behind the sealed cover 111, and the substrate is arranged on the base 112. The substrate is protected by a protective cover 114. Here, the cover 111 is made of an Al (aluminum) material with high heat conductivity. The making material is not limited to Al, and may be a material with high heat conductivity such as Cu. Al is desirable in consideration of the machining of the cover 111 into a desired shape. Further, the protective cover 114 is made of SPCC (cold-rolled steel sheet) such as zinc steel plate or iron plate. The protective cover 114 may also have a heat radiation function by use of an Al (aluminum) material or the like with high heat conductivity.

The base 112 is attached with a heat sink 115, which radiates heat emitted from the optical module 101 as heat generator (heat source), the substrate mounting the circuits thereon, or the like to the outside. The heat sink 115 is made of a material with high heat conductivity such as Al and has a plurality of fins in order to increase its surface area. Here, the base 112 may also have a heat radiation function by use of the Al material with high heat conductivity similarly to the cover 111 and the heat sink 115.

When the amounts of lights of the laser diodes 1a, 1b, and 1c decrease due to an increase in temperature while the scan-type image projection display device 110 is being used, an image color deviation such as entirely-reddish screen is caused. In particular, when white color is to be kept depending on the amount of lights of the red laser diode 1a, which is conspicuous in a reduction in the amount of lights due to an increase in temperature, the amounts of lights of green and blue need to be decreased. Thus, the amount of lights on the entire screen remarkably decreases. Further, driving the laser diodes 1a, 1b, and 1c at a high temperature is a cause of shorter life of the laser diodes. Therefore, heat radiation members, such as the base 112 and the heat sink 115 attached to the optical module 101, are required in order to restrict an increase in temperature when the laser diodes 1a, 1b, and 1c are driven. When a heat radiation member is mounted on an automobile or the like, it may be connected to the casing of its mounted device instead of the heat sink 115, thereby securing the heat radiation property.

Here, the enhancement in the heat radiation property of the laser diodes 1a, 1b, and 1c can restrict an increase in temperature of the laser diodes 1a, 1b, and 1c and can prevent a reduction in the amount of lights, and thus an effect of lower power consumption can be also expected.

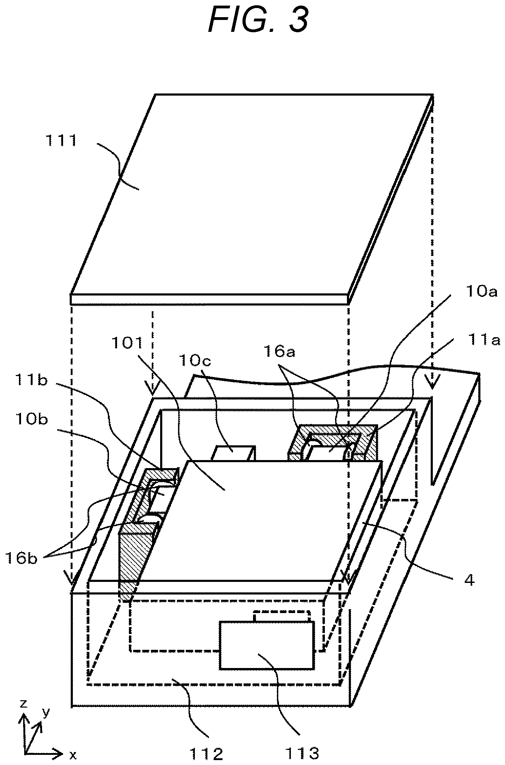

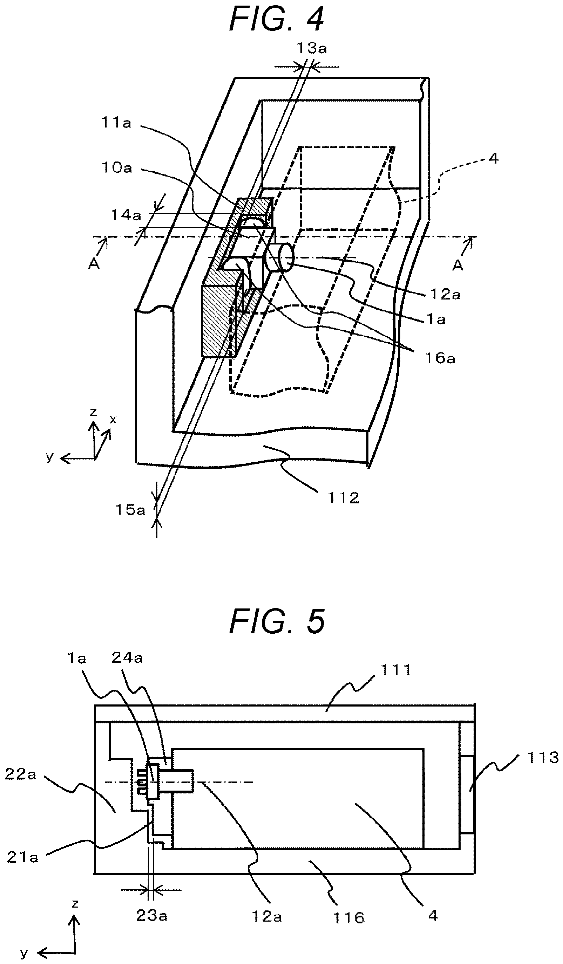

A specific configuration of the heat radiation will be described below with reference to FIG. 3 and FIG. 4. FIG. 3 is a perspective view illustrating protruded structures 11a and 11b according to one embodiment of the present invention, and FIG. 4 is a perspective view of part of the optical module 101 illustrating the protruded structure 11a according to one embodiment of the present invention.

In FIG. 3, the optical module 101 is attached to a module casing 4 via laser holders 10a, 10b, and 10c which hold the first laser diode 1a, the second laser diode 1b, and the third laser diode 1c corresponding to the laser diodes 1a, 1b, and 1c, respectively. The module casing 4 is connected to the base 112 in order to promote heat of the laser diodes 1a, 1b, and 1c to be discharged.

The base 112 is provided with a wall (side) therearound to seal the optical module 101, and is equipped with the sealing glass 113 at the emission port capable of emitting a coupled laser beam, and is mounted with the cover 111 so that its air tightness is kept. The optical module employs the laser diodes 1a, 1b, and 1c, and thus the diameter of an optical flux of laser beams is small. Thus, when dusts or the like traverse a laser beam, the dusts are displayed to be dark on the screen, which largely influences an image, and thus the heat radiation function is configured to seal the optical module 101 in order to prevent entry of dusts and the like. Here, if effects on images such as clean surrounding environment or dusts may be ignored, the cover 111 may be a protective cover with no sealing function.

As illustrated in FIG. 4, the protruded part 11a protrudes from the base 112 to approach the laser holder 10a mounted with the first laser diode 1a. The protruded part 11a is opened in a direction (z-axis direction) in which the optical module 101 is mounted on the base 112, thereby securing the assembly performance.

The direction in which the optical module 101 is mounted (attached) is a direction in which the optical module 101 is entirely positioned and supported.

The laser holder 10a mounted with the laser diode 1a makes optical axis adjustment in a plane (zx plane) normal to an optical axis 12a, and thus a distance 13a in the optical axis 12a direction between the laser holder 10a and the protruded part 11a is shorter than distances 14a and 15a between the laser holder 10a and the protruded part 11a in the plane (zx plane) normal to the optical axis 12a. A heat conductive material 16a is applied between the laser holder 10a and the protruded part 11a thereby to configure a heat conductive path. The heat conductive material 16a may employ a material such as grease or gel.

In the heat conductive path without the protruded part 11a, heat is transferred from the laser diode 11a as heat generator via the laser holder 10a to the module casing 4 and the heat is transferred from the module casing 4 to the base 112. To the contrary, the heat conductive path with the protruded part 11a is excellent in heat radiation efficiency so that heat is directly transferred from the laser diode 11a as heat generator via the laser holder 10a to the base 112.

The shape of the protruded part 11a is desirably similar to that of the laser holder 10a to easily approach the laser holder 10a. At this time, it is assumed for the laser holder 10a that at least two planes other than the plane (positive z-axis plane) in which the optical module 101 is attached, among the six planes including the positive x-axis plane, the negative x-axis plane, the positive y-axis plane, the negative y-axis plane (the optical axis 12a direction), the positive z-axis plane, and the negative z-axis plane about the laser holder 10a, are close to the laser holder 10a and are applied with the heat conductive material 16a. That is, the plane (the positive z-axis plane) in which the optical module 101 is attached is opposite to the direction in which the optical module 101 is attached on the base 112 relative to the laser holder 10a. Ideally, four planes other than the direction (the positive z-axis plane) in which the optical module 101 is attached and the plane (the negative y-axis plane) of the module casing 4 attached with the laser holder 10a are provided with a plane corresponding to the protruded part 11a and the laser holder 10a, and are applied with the heat conductive material 16a.

Here, the positional relationship between the laser holders 10a, 10b and the protruded parts 11a, 11b accords to the optical axes 12a, 12b of the corresponding laser diodes 1a, 1b. Further, in FIG. 3, the protruded parts 11a and 11b are provided at the red laser diode 1a which is conspicuous in a reduction in the amount of lights due to an increase in temperature, and the green laser diode 1b with the largest amount of generated heat, thereby achieving higher heat radiation efficiency of the laser diodes 1a and 1b. The protruded part 11a may be provided only at the red laser diode 1a which is conspicuous in a reduction in the amount of lights due to an increase in temperature.

The optical axis 12a is arranged in the xy plane in the Figure, but the optical axis 12a may be offset, specifically the optical axis 12a may be obliquely arranged at an angle relative to the zx plane due to an installation position of the scan-type image projection display device 110. When the optical axis 12a is obliquely arranged, the plane of the laser holder 10a and the plane of the protruded part 11a are obliquely provided according to the optical axis 12a of the corresponding laser diode 1a. Similarly, the optical axis 12a may be arbitrarily offset upward, downward, leftward, or rightward.

The protruded parts 11a and 11b are provided thereby to enhance the heat radiation property, which can achieve the optical module 101 and the scan-type image projection display device 110 capable of displaying a bright image even at a high environment temperature at lower power consumption without an increase in size of the optical module 101.

### Second embodiment

FIG. 5 illustrates a cross-section view (cross-section taken along A-A in FIG. 4) of a second embodiment of the present invention. In FIG. 5, the heat conductive material 16a is not illustrated for a clear relationship between members, but is applied between a protruded part 22a and a laser holder 24a.

As the above-described distance 13a between the laser holder 10a and the protruded part 11a is shorter, the heat radiation property is further enhanced. However, a terminal of the laser diode 1a is behind the optical axis 12a of the laser diode 11a, and when the terminal contacts with the protruded part 11a, the laser diode 1a is damaged, and thus the distance 13a needs to be carefully shortened. The protruded part 22a and the laser holder 24a are configured in order to further shorten the distance 13a such that the laser holder 24a is extended into the plane (the xy plane) normal to the optical axis 12a, a plane 21a approachable to the protruded part 22a, where the terminal of the laser diodes 1a is not present, is provided thereby to shorten a distance 23a between the laser holder 24a and the protruded part 22a and to achieve an enhancement in heat radiation property.

The proximate plane 21a for the protruded part 22a and the laser holder 24a is provided thereby to enhance the heat radiation property, which can achieve the optical module 101 and the scan-type image projection display device 110 capable of displaying a bright image even at a high environment temperature at low power consumption without an increase in size of the optical module 101.

Here, when the direction in which the laser holder 24a is extended is extended in the direction (z-axis direction) in which the optical module 101 is assembled, the areas of the protruded part 22a and the proximate plane 21a do not change irrespective of their movement (movement of the zx plane) due to adjustment of the laser diode 1a, thereby achieving the optical module 101 and the scan-type image projection display device 110 capable of restricting a variation in heat radiation capability and easily controlling a temperature.

In FIG. 5, the proximate plane 21a of the laser holder 24a is provided on the base 113 side to be closer to the module casing 4 than to the laser diode terminal, but the proximate plane 21a of the laser holder 24a may be provided to be protruded from the laser holder 22a on the cover 111 side to be closer to a base 116 than to the laser diode terminal in a similar configuration.

### Third embodiment

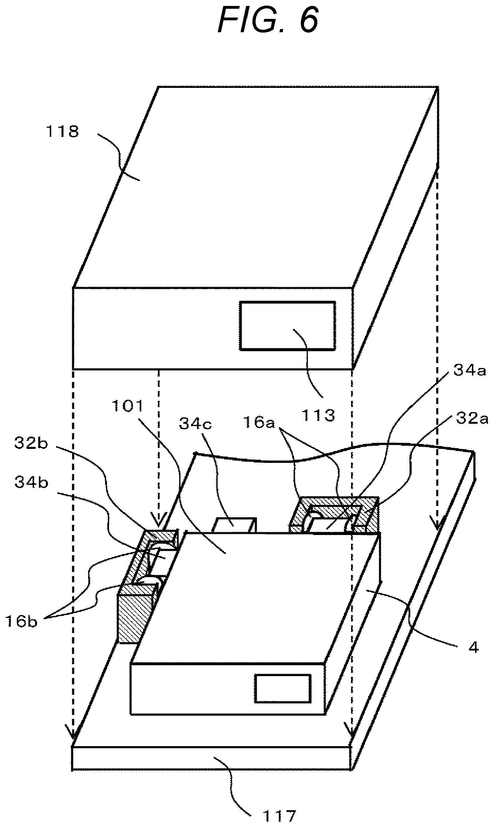

FIG. 6 is a perspective view of a configuration of protruded parts according to a third embodiment of the present invention. A wall (side) is provided around the optical module 101 on the base 112 according to the first embodiment, while a wall (side) around the optical module 101 is closer to a cover 118 and a protruded part 32a is provided on a base 117. A wall (side) around the optical module 101 is provided on the cover 118 so that adjustment, application of the heat conductive materials 16a, 16b, and visual confirmation are facilitated from the outside when the optical module 101 is attached, and the assembly performance can be enhanced.

The base 117 provided with the protruded part 32a and the cover 118 are provided thereby to achieve the optical module 101 and the scan-type image projection display device 110 capable of enhancing the heat radiation property with excellent assembly performance without an increase in size of the optical module 101, and capable of displaying a bright image even at a high environment temperature at low power consumption.

### Fourth embodiment

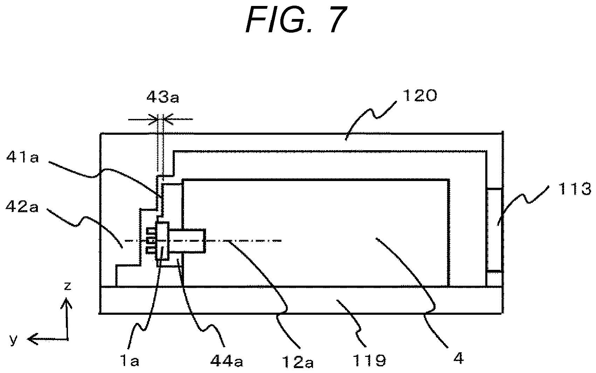

FIG. 7 is a cross-section view of a configuration of a protruded part according to a fourth embodiment of the present invention. In FIG. 7, the heat conductive material 16a is not illustrated for a clear relationship between members, but is applied between a protruded part 42a and a laser holder 44a. The protruded part 42a is provided on a cover 120 and a base 119 has a plate shape. The laser holder 44a is extended in a direction (z-axis direction) in which the optical module 101 is assembled in the plane (xy plane) normal to the optical axis 12a, and is provided with a proximate plane 41a.

Since the base 119 has a plate shape, the base 119 can be easily machined and manufactured at low cost and no obstacle is present around the optical module 101, thereby facilitating adjustments when the optical module 101 is mounted on the base 119.

The cover 120 provided with the protruded part 42a and the base 119 can achieve the optical module 101 and the scan-type image projection display device 110 capable of enhancing the heat radiation property with excellent assembly performance without an increase in size of the optical module 101 and capable of displaying a bright image even at a high environment temperature at low power consumption.

The present invention is not limited to the above-described embodiments, and encompasses various variants. For example, the above-described embodiments have been described in detail for understandably explaining the present invention, and are not limited to ones including all the components. Further, part of the configuration of an embodiment may be replaced with the configuration of other embodiment, or the configuration of an embodiment may be added with the configuration of other embodiment. Further, some of the components in each embodiment may be added with, deleted, or replaced with other components.

### Reference Signs List

- 1a: first laser
- 1b: second laser
- 1c: third laser
- 2a: first collimator lens
- 2b: second collimator lens
- 2c: third collimator lens
- 3a: first beam coupling unit
- 3b: second beam coupling unit
- 4: module casing
- 10a: laser holder
- 10b: laser holder
- 10c: laser holder
- 11a: protruded part
- 11b: protruded part
- 12a: optical axis
- 12b: optical axis
- 12c: optical axis
- 13a: distance
- 13b: distance
- 14a: distance
- 14b: distance
- 15a: distance
- 15b: distance
- 16a: heat conductive material
- 16b: heat conductive material
- 21a: proximate plane
- 21b: proximate plane
- 22a: protruded part
- 22b: protruded part
- 23a: distance
- 23b: distance
- 24a: laser holder
- 24b: laser holder
- 24c: laser holder
- 32a: protruded part
- 32b: protruded part
- 34a: laser holder
- 34b: laser holder
- 34c: laser holder
- 41a: proximate plane
- 41b: proximate plane
- 42a: protruded part
- 42b: protruded part
- 43a: distance
- 43b: distance
- 44a: laser holder
- 44b: laser holder
- 44c: laser holder
- 100: laser diode module
- 101: optical module
- 102: control circuit
- 103: video signal processing circuit
- 104: laser diode drive circuit
- 105: scanning mirror drive circuit
- 106: front monitor signal detection circuit
- 107: screen
- 108: scanning mirror
- 109: front monitor
- 110: scan-type image projection display device
- 111: cover
- 112: base
- 113: emission port glass
- 114: cover
- 115: heat sink
- 116: base
- 117: base
- 118: cover
- 119: base
- 120: cover

## Claims

1. An optical module for coupling and irradiating laser beams from a plurality of laser diodes onto a desired position, the optical module having a base for placing the optical module thereon, and a cover for covering the optical module, wherein the base is provided with a protruded part, and a heat conductive material is provided between the protruded part and a laser holder for holding a laser diode.

2. The optical module according to claim 1,
wherein the base for placing the optical module thereon is provided with a first protruded part corresponding to a first laser holder for holding a first laser diode, and a second protruded part corresponding to a second laser holder for holding a second laser diode, and
a heat conductive material is provided between the first protruded part and the first laser holder and between the second protruded part and the second laser holder.

3. The optical module according to claim 2,
wherein the first laser diode is a red laser diode and the second laser diode is a green laser.

4. The optical module according to claim 2,
wherein a distance between a protruded part in an optical axis direction of a laser diode and the laser holder, in which a heat conductive material is applied, is shorter than a distance between a protruded part in a direction other than the optical axis of the laser diode and the laser holder, in which a heat conductive material is applied.

5. The optical module according to claim 2,
wherein a plane of a protruded part having a similar shape to a laser holder is provided on at least two planes other than a plane in an opposite direction to the laser holder in which the optical module is attached on the base and a plane of a module casing in which the laser holder is attached, and
a heat conductive material is provided between the protruded part and the laser holder.

6. The optical module according to claim 4,
wherein the laser holder is extended in a direction in which the optical module is attached on the base viewed from the laser holder, and
a heat conductive material is provided between the extended laser holder and a protruded part.

7. The optical module according to claim 4,
wherein a cover is provided with the protruded part.

8. A scan-type image projection display device comprising:
an optical module for coupling laser beams from a plurality of laser diodes, and irradiating the laser beams coupled by a scanning mirror onto a desired position;
a video signal processing circuit for extracting a horizontal synchronization signal and a vertical synchronization signal from an externally-input image signal;
a laser diode drive circuit for supplying a drive current to each of the laser diodes; and
a scanning mirror drive circuit for controlling the scanning mirror on the basis of the horizontal synchronization signal and the vertical synchronization signal,
wherein a base for placing the optical module thereon is provided with a first protruded part corresponding to a first laser holder for holding a first laser diode and a second protruded part corresponding to a second laser holder for holding a second laser diode, and
a heat conductive material is provided between the first protruded part and the first laser holder and between the second protruded part and the second laser holder.
